# EUROPEAN PATENT APPLICATION

(11) **EP 2 418 924 A1**
(43) Date of publication of application: **15.02.2012**
(21) Application number: 11250705.8
(22) Date of filing: 05.08.2011
(51) Int. Cl.: H05K 1/16, H05K 1/03, H05K 1/09

(54) **Method of manufacturing antenna using sintering of metal and antenna manufactured by the same**

(30) Priority: 12.08.2010 KR 20100077832
(71) Applicant: Dynatron Co., Ltd., Seongnam-si, Gyeonggi-do (KR)
(72) Inventor: Bang, Kug Hyeon, Gangnam-gu Seoul (KR)
(74) Representative: Dunlop, Brian Kenneth Charles

(57) **Abstract**

A method of manufacturing an antenna (100) includes forming a base (120) including a synthetic resin, forming a conductive pattern on the base and forming a circuit pattern (140) by sintering the conductive pattern by applying heat. The conductive pattern includes a conductive paste and a binding material binding the base and the conductive pattern. The conductive paste includes a metal.

## Description

### BACKGROUND OF THE INVENTION

### 1. Field of the Invention

Example embodiments of the present invention relate to a method of manufacturing an antenna and an antenna manufactured by the method. More particularly, example embodiments of the present invention relate to a method of manufacturing an antenna capable of simplifying a manufacturing process using sintering of a metal and an antenna manufactured by the method.

### 2. Description of the Related Art

As communication technology, in particular mobile communication technology, has been developed along with development of electronic industry, various mobile communication terminals capable of implementing data communication wherever they are become common. Generally, the mobile communication terminal may include a cellular phone, a smart phone, a personal digital assistant (PDA), a netbook computer and a laptop computer, which are portable and capable of implementing various functions using mobile communication and an application program.

A whip antenna having a straight metal rod, a helical antenna having a helix shaped metal wire and a retractable antenna are conventionally used for the mobile communication terminal. Recently, an internal antenna is applied to the mobile communication terminal to satisfy consumers' demand for a slim and miniaturized terminal.

A thermal bonding method and a double injection method are conventionally used to manufacture the internal antenna.

In the thermal bonding method, a base including protrusions is formed by injection molding of synthetic resin. An antenna circuit pattern is designed on the base. A press mold having a shape corresponding to the antenna circuit pattern is fabricated. Then, a thin copper plate or a thin stainless plate is bended and then is combined with the protrusions of the base. The thin copper plate or the thin stainless plate is fixed to the base by thermal bonding process. The thermal bonding method may be not proper to an antenna having a three-dimensional shape or a complex shape. The thermal bonding method has a lot of processes so that productivity may be relatively low and manufacturing cost may be relatively high.

In the double injection method, an antenna circuit pattern is designed on a base according to an internal space for the internal antenna. The base including the circuit pattern is formed by a double injection process using an injection mold for the base and an injection mold for the circuit pattern combined with each other. A copper plating film and a nickel plating film are formed on the circuit pattern. Defect rate of the double injection process may be relatively high. The plating process is required so that the manufacturing processes may be complex. For example, the base generally includes a polycarbonate (PC) resin. The plating process may not be directly implemented on the base including a polycarbonate resin. Thus, a process to form the circuit pattern including an acrylonitrile-butadiene-styrene (ABS) resin is required. In addition, a process to form a binding layer to bind the circuit pattern and the plating film. As a result, the manufacturing method of the antenna using the double injection method has a lot of complex processes.

### SUMMARY OF THE INVENTION

Example embodiments of the present invention provide a method of manufacturing an antenna capable of simplifying a manufacturing process using sintering of a metal.

Example embodiments of the present invention also provide an antenna manufactured by the above-mentioned method.

In an example method of manufacturing an antenna according to the present invention, the method includes forming a base including a synthetic resin, forming a conductive pattern including a conductive paste and a binding material on the base and sintering the conductive pattern by applying heat to form a circuit pattern. The conductive paste includes a metal. The binding material binds the base and the conductive pattern.

In an example embodiment, the base may further include a glass.

In an example embodiment, a sintering temperature of the conductive pattern may be lower than a melting point of the base.

In an example embodiment, a size of a particle of the conductive paste may be between about 30nm and about 50nm

In an example embodiment, the conductive paste may be a silver paste.

In an example antenna according to the present invention, the antenna includes a base and a circuit pattern. The base includes a synthetic resin. The circuit pattern is formed by sintering a conductive pattern including a conductive paste and a binding material on the base by applying heat. The conductive paste includes a metal. The binding material binds the base and the conductive pattern.

In an example embodiment, the base may further include a glass.

In an example embodiment, a sintering temperature of the conductive pattern may be lower than a melting point of the base.

In an example embodiment, a size of a particle of the conductive paste may be between about 30nm and about 50nm.

In an example embodiment, the conductive paste may be a silver paste.

According to a method of manufacturing an antenna and an antenna manufactured by the method, a metal may be sintered directly on a base to form a circuit pattern. Thus, the method of manufacturing an antenna may be simplified.

In addition, a shape of the antenna may be simplified, miniaturized and slim.

Furthermore, a metal plating process may be omitted so that bad influence on health and environment caused in the metal plating process may be prevented.

### BRIEF DESCRIPTION OF THE DRAWINGS

The above and other features and advantages of the present invention will become more apparent by describing in detailed example embodiments thereof with reference to the accompanying drawings, in which:

FIG. 1 is a perspective view illustrating an antenna according to an example embodiment of the present invention;

FIG. 2 is a cross-sectional view illustrating the antenna taken along a line I-I' of FIG. 1;

FIG. 3 is a flowchart illustrating a method of manufacturing the antenna of FIG. 1;

FIGS. 4A to 4C are perspective views to explain the method of manufacturing the antenna of FIG. 1;

FIG. 5 is a perspective view illustrating a portion of an antenna according to another example embodiment of the present invention; and

FIGS. 6A to 6C are perspective views to explain the method of manufacturing the antenna of FIG. 5.

### DETAILED DESCRIPTION OF THE INVENTION

The present invention is described more fully hereinafter with reference to the accompanying drawings, in which example embodiments of the present invention are shown. The present invention may, however, be embodied in many different forms and should not be construed as limited to the example embodiments set forth herein. Rather, these example embodiments are provided so that this disclosure will be thorough and complete, and will fully convey the scope of the present invention to those skilled in the art. In the drawings, the sizes and relative sizes of layers and regions may be exaggerated for clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular example embodiments only and is not intended to be limiting of the present invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments of the invention are described herein with reference to cross-sectional illustrations that are schematic illustrations of idealized example embodiments (and intermediate structures) of the present invention. As such, variations from the shapes of the illustrations as a result, for example, of manufacturing techniques and/or tolerances, are to be expected. Thus, example embodiments of the present invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present invention will be explained in detail with reference to the accompanying drawings.

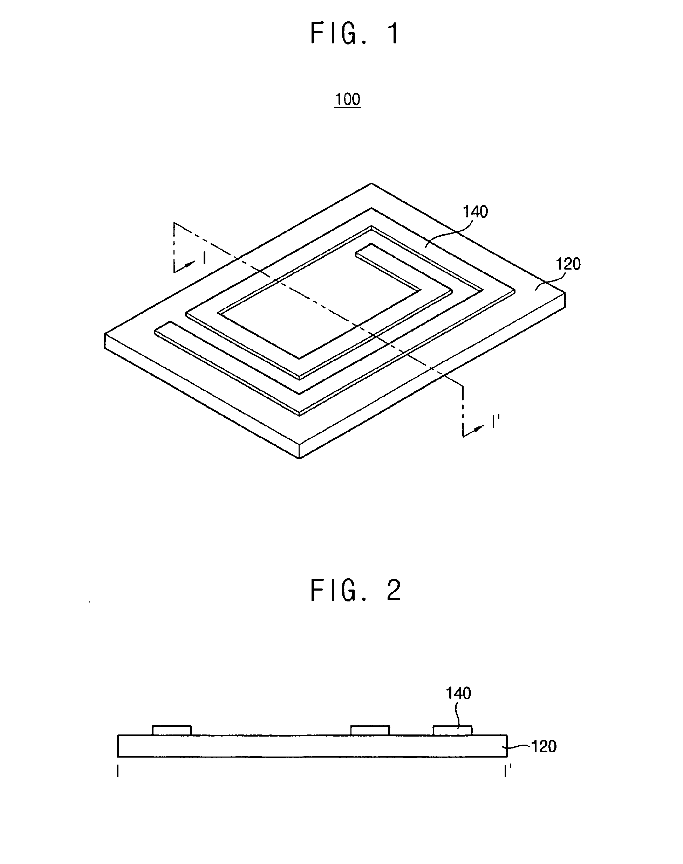

FIG. 1 is a perspective view illustrating an antenna according to an example embodiment of the present invention.

Referring to FIG. 1, the antenna 100 according to the present example embodiment includes a base 120 and a circuit pattern 140.

The base 120 may be formed in various shapes considering a shape of a mobile communication terminal or a shape of a portion for the antenna 100 in the mobile communication terminal. The base 120 may be integrally formed with a plane of the mobile communication terminal. Alternatively, the base 120 may be a plane of the mobile communication terminal.

The base 120 may include a synthetic resin. For example, the base 120 may include a polycarbonate (PC) resin, a polyethylene resin, a polypropylene resin, a polystyrene resin, a polyvinyl alcohol resin, a vinyl chloride resin, an ionomer resin, a polyamide resin, acrylonitrile-butadiene-styrene (ABS) resin and so on. The base 120 may preferably include a PC resin.

The base 120 may further include a glass. When the base 120 further includes a glass, a melting point of the base 120 is increased comparing to the base 120 only including the synthetic resin. Thus, the base 120 may resist a relatively high heat.

A shape of the base 120 may correspond to a shape of the circuit pattern 140.

The circuit pattern 140 is formed on the base 120. The circuit pattern 140 may have a planar shape as shown in FIG. 1. The circuit pattern 140 may have a bar shape bended with several times as shown in FIG. 1. However, the circuit pattern 140 may have various shapes considering a shape of the mobile communication terminal and a range of a frequency of the mobile communication terminal, so that the shape of the circuit pattern 140 is not limited as illustrated in FIG. 1.

The circuit pattern 140 is formed using a conductive paste. The circuit pattern 140 may be formed using an ink including the conductive paste. The conductive paste includes a metal. The conductive paste may include gold (Au), silver (Ag), platinum (Pt), palladium (Pd), copper (Cu) and so on. The conductive paste may preferably include the silver.

A size of a particle of the conductive paste may be very small. A size of a particle of the conductive paste may be between about 30nm and about 50nm. When the size of the particle of the conductive paste is very small, the conductive paste may be sintered in a relatively low temperature.

The conductive paste may include a binding material. When the conductive paste includes the binding material, the circuit pattern 140 may be tightly attached to the base 120. In addition, an additional process to form a binding layer may be omitted.

The ink including the conductive paste is printed on the base 120. Then, heat is applied to the ink to sinter the conductive paste so that the circuit pattern 140 is formed.

The base 120 further includes a glass so that a melting point of the base 120 increases. An amount of a glass is adjusted to increase the melting point of the base 120 over a sintering temperature of the ink, so that the circuit pattern 140 may be formed without damage of the base 120.

In addition, a size of the particle of the conductive paste is very small so that the ink is sintered at a relatively low temperature. A size of the particle is adjusted to decrease a sintering temperature of the ink under the melting point of the base 120, so that the circuit pattern 140 may be formed without damage of the base 120.

FIG 2 is a cross-sectional view illustrating the antenna taken along a line I-I' of FIG 1.

Referring to FIGS. 1 and 2, the circuit pattern 140 is protruded from the base 120. In the present example embodiment, an additional career layer including an ABS resin and a binding layer binding the career layer with the circuit patter 140 are not required to be formed on the base 120 so that a shape of the antenna 100 may be simplified, miniaturized and slim.

As illustrated in FIG. 2, the circuit pattern 140 is protruded from the base 120 according to the present example embodiment. Alternatively, the base 120 may include a recess portion, and the circuit pattern 140 may be formed in the recess portion of the base 120 so that the circuit pattern 140 may be not protruded from the base 120. Furthermore, an upper surface of the circuit pattern 140 may be substantially in a plane with an upper surface of the base 120.

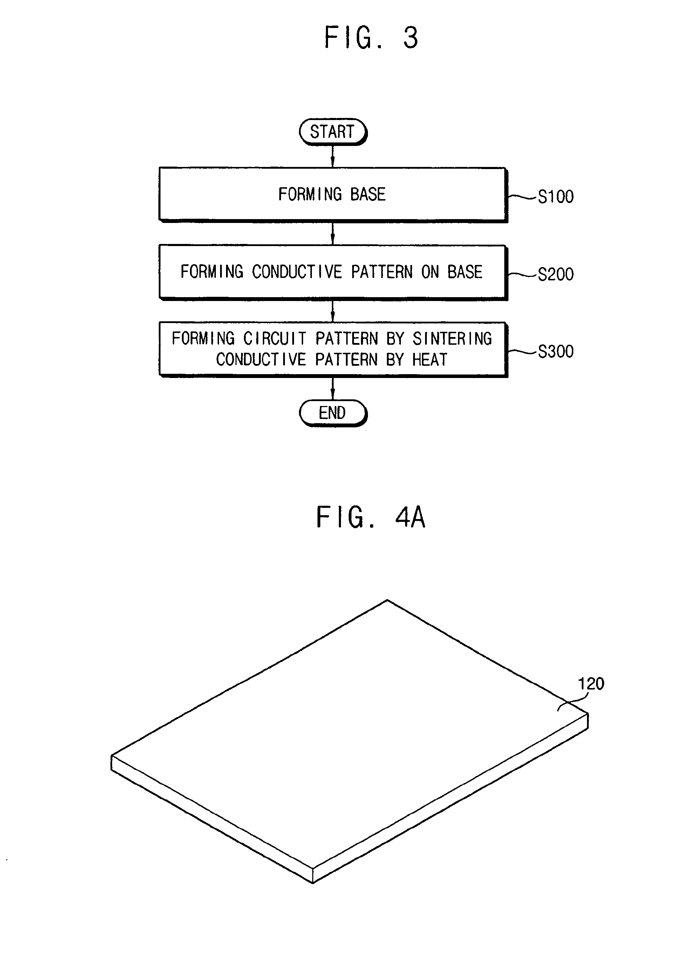

FIG. 3 is a flowchart illustrating a method of manufacturing the antenna of FIG. 1. FIGS. 4A to 4C are perspective views to explain the method of manufacturing the antenna of FIG. 1.

Referring to FIGS. 3 and 4A, the base 120 of the antenna 100 is formed (step S100). The base 120 includes a synthetic resin. The base 120 may be formed by an injection molding. For example, a press mold having a shape corresponding to the base 120 is fabricated. A melted synthetic resin is inserted into the press mold. Then, the base 120 is formed after a predetermined time. As mentioned above, the base 120 has a rectangular plate shape as illustrated in FIG. 1. Alternatively, the base 120 may have various shapes.

The base 120 may further include a glass. When the base 120 further includes a glass, a melting point of the base 120 is increased comparing to the base 120 only including the synthetic resin. Thus, the base 120 may resist heat more.

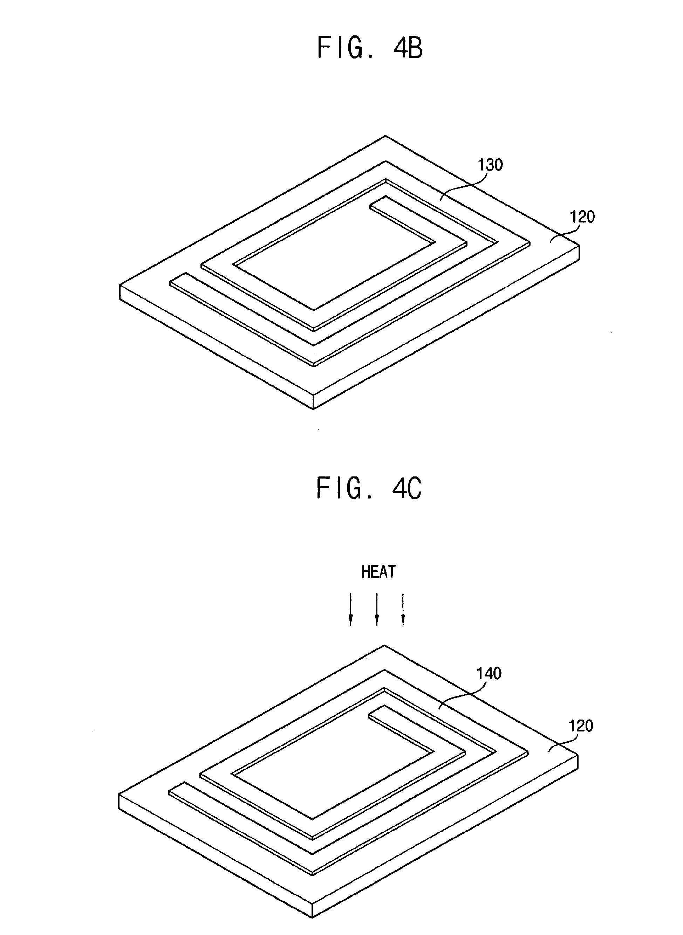

Referring to FIGS. 3 and 4B, a conductive pattern 130 is formed on the base 120 (step S200). The conductive pattern 130 includes the conductive paste. The conductive pattern 130 has a shape corresponding to the shape of the circuit pattern 140. The conductive paste may include a metal material and a binding material. For example, the conductive paste may include the silver.

A size of a particle of the conductive paste may be very small. For example, a size of a particle of the conductive paste may be between about 30nm and about 50nm. When the size of the particle of the conductive paste is very small, the conductive paste may be sintered in a relatively low temperature.

The conductive pattern 130 may be formed using a screen print method, a pad print method and an inkjet print method.

In the screen print method, a metal or a polymer mask is disposed on the base 120. The conductive paste is spread on the mask. The conductive paste 130 is squeezed to form the conductive pattern 130.

In the pad print method, the ink including the conductive paste having a shape of the circuit pattern 140 is absorbed into a flat pad. The absorbed ink is transferred to the base 120 to form the conductive pattern 130. Here, the pad may include silicon.

In the inkjet print method, an information or data on a shape of the circuit patter 140 is inputted to a computer. An inkjet printer including an ink spray nozzle sprays out the ink on the base 120 to form the conductive pattern 130.

Referring to FIGS. 3, 4B and 4C, heat is applied to the conductive pattern 130 to sinter the conductive pattern 130 so that the circuit patter 140 is formed (step S300). A sintering furnace (not shown) may be used in the sintering process. The sintering furnace applies heat to the base 120 and the conductive pattern 130 to sinter the conductive pattern 130, so that the circuit patter 140 is formed.

Sintering is a method for adhering particles with each other to form a desired shape by heating the particles under a melting point of the particles. A driving force of sintering may be a surface energy of the particles. When the particles are not combined with each other, a total sum of the surface energy of the particles is not the minimum value so that the particles are not in thermodynamic equilibrium. When applying heat to the particles, the particles are combined with each other to decrease the total sum of the surface energy of the particles and a total surface area of the particles.

Accordingly, when heat is applied to the conductive pattern 130, the conductive pattern 130 is sintered. Thus, particles not having solidity are granulated and densified so that the particles are combined with each other to form a lump. By sintering, the surface area of the conductive pattern 130 is decreased, and solidity of the conductive pattern 130 is increased. In addition, electrical conductivity of the conductive pattern 130 is increased and resistance of the conductive patter 130 is decreased so that the conductive pattern 130 may function as a circuit. Therefore, the circuit pattern 140 formed by sintering of the conductive patter 130 have proper resistance to function as a circuit.

When applying heat to sinter the conductive pattern 130, the base 120 may be physically or chemically damaged. However, the base 120 includes a glass so that a melting point of the base 120 increases. An amount of a glass is adjusted to increase a melting point of the base 120 over a sintering temperature of the ink so that the circuit pattern 140 may be formed without damage of the base 120.

In addition, a size of the particle of the conductive paste is very small so that the ink is sintered at a relatively low temperature. A size of the particle is adjusted to decrease a sintering temperature of the ink under a melting point of the base 120 so that the circuit pattern 140 may be formed without damage of the base 120.

According to a method of manufacturing antenna 100 of the present example embodiment, the conductive pattern 130 is directly sintered on the base 120 to form the circuit pattern 140. Accordingly, forming a career layer on the base 120, forming a binding layer on the career layer and forming a plating layer on the binding layer are not required so that manufacturing processes of the antenna 100 are simplified. Therefore, a shape of the antenna 100 may be simplified, miniaturized and slim.

In addition, bad influence on health and environment caused in the plating process may be prevented.

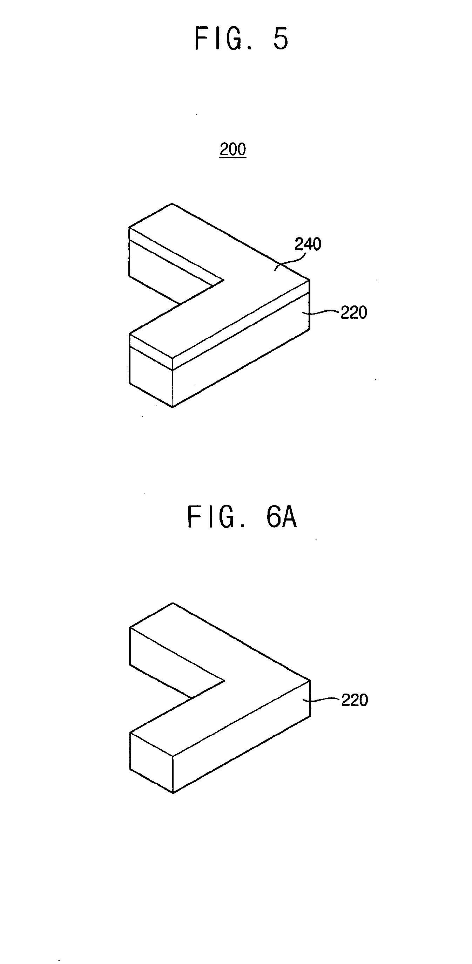

FIG. 5 is a perspective view illustrating a portion of an antenna according to another example embodiment of the present invention.

Referring to FIG. 5, the antenna according to the present example embodiment includes a base 220 and a circuit pattern 240.

The antenna 200 according to the present example embodiment is substantially the same as the antenna 100 according to the previous example embodiment of FIG. 1 except that the antenna 200 has a three dimensional shape. Thus, any repetitive explanation will be omitted.

The base 220 may be formed in various shapes considering a shape of a mobile communication terminal or a shape of a portion for the antenna 100 in the mobile communication terminal.

The base 220 may include a synthetic resin. For example, the base 220 may include a PC resin.

The base 220 may further include a glass. When the base 220 further includes a glass, a melting point of the base 220 is increased comparing to the base 220 only including the synthetic resin. Thus, the base 220 may resist heat more.

A shape of the base 220 may correspond to a shape of the circuit pattern 240.

The circuit pattern 240 is formed on the base 220. The circuit pattern 240 may have a planar shape as shown in FIG. 5. Alternatively, the circuit pattern 240 may have a three dimensional shape. Accordingly, the circuit pattern 240 may be formed corresponding to a plurality of surfaces of the base 220. In addition, the circuit pattern 240 may cover only a portion of a surface. The circuit pattern 240 may have various shapes considering a shape of the mobile communication terminal and a range of a frequency of the mobile communication terminal.

The circuit pattern 240 is formed using a conductive paste. The circuit pattern 240 may be formed using an ink including the conductive paste. For example, the conductive paste may include the silver.

A size of a particle of the conductive paste may be very small. For example, a size of a particle of the conductive paste may be between about 30nm and about 50nm. When the size of the particle of the conductive paste is very small, the conductive paste may be sintered in a relatively low temperature.

The conductive paste may include a binding material. When the conductive paste includes the binding material, the circuit pattern 240 may be tightly attached to the base 220. In addition, an additional process to form a binding layer may be omitted.

The ink including the conductive paste is printed on the base 220. Then, heat is applied to the ink to sinter the conductive paste so that the circuit pattern 240 is formed.

FIGS. 6A to 6C are perspective views to explain the method of manufacturing the antenna of FIG. 5.

The method of manufacturing the antenna 200 according to the present example embodiment is substantially the same as the method of manufacturing the antenna 100 according to the previous example embodiment of FIG. 3 except that the antenna 200 has a three dimensional shape. Thus, any repetitive explanation will be omitted.

Referring to FIGS. 3 and 6A, the base 220 of the antenna 200 is formed (step S100). The base 220 includes a synthetic resin. The base 220 may be formed by an injection molding.

The base 220 may further include a glass. When the base 220 further includes a glass, a melting point of the base 220 is increased comparing to the base 220 only including the synthetic resin. Thus, the base 220 may resist heat more.

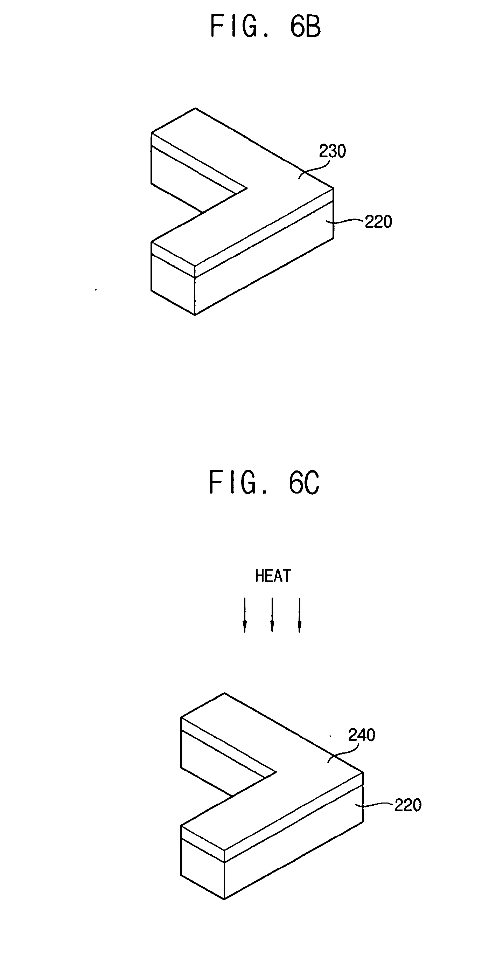

Referring to FIGS. 3 and 6B, a conductive pattern 230 is formed on the base 220 (step S200). In the present example embodiment, though the conductive pattern 230 is formed on a single surface of the base 220, the conductive pattern 230 may be formed corresponding to a plurality of surfaces of the base 220. In addition, the conductive pattern 230 may cover only a portion of a surface.

The conductive pattern 230 includes the conductive paste. The conductive pattern 230 has a shape corresponding to the shape of the circuit pattern 240. The conductive paste may include a metal material and a binding material. For example, the conductive paste may include the silver.

A size of a particle of the conductive paste may be very small. For example, a size of a particle of the conductive paste may be between about 30nm and about 50nm. When the size of the particle of the conductive paste is very small, the conductive paste may be sintered in a relatively low temperature.

The conductive pattern 230 may be formed using a screen print method, a pad print method and an inkjet print method.

In the screen print method, the conductive pattern 230 is formed using a metal or a polymer mask. In the pad print method, the conductive paste is absorbed into a flat pad, and the absorbed ink is transferred to the base 220 to form the conductive pattern 230. In the inkjet print method, the conductive pattern 230 is formed on the base 220 using an inkjet printer including an ink spray nozzle.

Referring to FIGS. 3, 6B and 6C, heat is applied to the conductive pattern 230 to sinter the conductive pattern 230 so that the circuit patter 240 is formed (step S300). A sintering furnace (not shown) may be used in the sintering process.

By sintering, the surface area of the conductive pattern 230 is decreased, and solidity of the conductive pattern 230 is increased. In addition, electrical conductivity of the conductive pattern 230 is increased and resistance of the conductive patter 230 is decreased so that the conductive pattern 230 may function as a circuit. Therefore, the circuit pattern 240 formed by sintering of the conductive patter 230 have proper resistance to function as a circuit.

When applying heat to sinter the conductive patter 230, the base 220 may be physically or chemically damaged. However, the base 220 includes a glass so that a melting point of the base 220 increases. An amount of a glass is adjusted to increase a melting point of the base 220 over a sintering temperature of the ink so that the circuit pattern 240 may be formed without damage of the base 220.

In addition, a size of the particle of the conductive paste is very small so that the ink is sintered at a relatively low temperature. A size of the particle is adjusted to decrease a sintering temperature of the ink under a melting point of the base 220 so that the circuit pattern 240 may be formed without damage of the base 220.

According to a method of manufacturing antenna 200 of the present example embodiment, the conductive pattern 230 is directly sintered on the base 220 to form the circuit pattern 240. Accordingly, forming a career layer on the base 220, forming a binding layer on the career layer and forming a plating layer on the binding layer are not required so that manufacturing processes of the antenna 200 are simplified.

For example, when the antenna 200 has a three dimensional shape, the method of manufacturing antenna of the present example embodiment may be proper and useful unlike other methods such as a thermal bonding method.

In addition, a shape of the antenna 200 may be simplified, miniaturized and slim.

Furthermore, bad influence on health and environment caused in the plating process may be prevented.

The foregoing is illustrative of the present invention and is not to be construed as limiting thereof. Although a few example embodiments of the present invention have been described, those skilled in the art will readily appreciate that many modifications are possible in the example embodiments without materially departing from the novel teachings and advantages of the present invention. Accordingly, all such modifications are intended to be included within the scope of the present invention as defined in the claims. In the claims, means-plus-function clauses are intended to cover the structures described herein as performing the recited function and not only structural equivalents but also equivalent structures. Therefore, it is to be understood that the foregoing is illustrative of the present invention and is not to be construed as limited to the specific example embodiments disclosed, and that modifications to the disclosed example embodiments, as well as other example embodiments, are intended to be included within the scope of the appended claims. The present invention is defined by the following claims, with equivalents of the claims to be included therein.

As explained above, according to the present invention, a metal may be sintered directly on a base to form a circuit pattern. Thus, the method of manufacturing an antenna may be simplified.

In addition, a shape of the antenna may be simplified, miniaturized and slim.

Furthermore, bad influence on health and environment caused in the plating process may be prevented.

## Claims

1. A method of manufacturing an antenna, the method comprising:
forming a base including a synthetic resin;
forming a conductive pattern including a conductive paste and a binding material on the base, the conductive paste including a metal, the binding material binding the base and the conductive pattern; and
sintering the conductive pattern by applying heat to form a circuit pattern.

2. The method of claim 1, wherein the base further includes a glass.

3. The method of claim 1, wherein a sintering temperature of the conductive pattern is lower than a melting point of the base.

4. The method of claim 3, wherein a size of a particle of the conductive paste is between about 30nm and about 50nm.

5. The method of claim 1, wherein the conductive paste is a silver paste.

6. An antenna comprising:
a base including a synthetic resin; and
a circuit pattern formed by sintering a conductive pattern including a conductive paste and a binding material on the base by applying heat, the conductive paste including a metal, the binding material binding the base and the conductive pattern.

7. The antenna of claim 6, wherein the base further includes a glass.

8. The antenna of claim 6, wherein a sintering temperature of the conductive pattern is lower than a melting point of the base.

9. The antenna of claim 8, wherein a size of a particle of the conductive paste is between about 30nm and about 50nm.

10. The antenna of claim 6, wherein the conductive paste is a silver paste.
